# EUROPÄISCHE PATENTANMELDUNG

(11) **EP 3 057 012 A1**
(43) Veröffentlichungstag der Anmeldung: **17.08.2016**
(21) Anmeldenummer: 15154841.9
(22) Anmeldetag: 12.02.2015
(51) Int. Cl.: G06F 17/50

(54) **Herstellen einer Maschine mit Teileklassifizierung**

(71) Anmelder: Siemens Aktiengesellschaft, 80333 München (DE)
(72) Erfinder: Frank, Gernot, 75365 Calw (DE)

(57) **Zusammenfassung**

Die Herstellung von Maschinen soll vereinfacht werden. Dazu werden ein Verfahren und eine Vorrichtung vorgeschlagen, bei denen in einem Entwicklungsprojekt (5) ein Lösungsprinzip (W) real implementiert wird (I). Automatisch wird dadurch in einer Teilebibliothek (8) eine entsprechende Klasse (K) und die Implementierung (I) hinterlegt. Bei einer erneuten Implementierung kann so auf die Teilebibliothek zurückgegriffen werden.

## Beschreibung

Die vorliegende Erfindung betrifft ein Verfahren zum Herstellen einer Maschine. Darüber hinaus betrifft die vorliegende Erfindung eine entsprechende Vorrichtung zum Herstellen einer Maschine.

Kürzere Produktlebenszyklen und individuellere Produkte verlangen bei produzierenden Unternehmen eine schnellstmögliche Anpassung ihres Produktionssystems hinsichtlich einer optimierten Prozesskette. Durch neue Produktionsverfahren und integrierte Prozesse wird ein erhebliches Optimierungspotenzial freigesetzt. Dies führt zu einem steigenden Bedarf an kundenindividuellen Maschinen. Folge davon ist wiederum, dass eine entsprechende Sondermaschinenentwicklung höchsteffizient gestaltet werden muss.

Im Wesentlichen können zwei Kategorien von Ansätzen zur schnelleren Maschinenentwicklung identifiziert werden. Die erste versucht, Maschinen strikt zu modularisieren, wodurch die Modulentwicklung von der Auftragsabwicklung getrennt wird. Die zweite Kategorie fokussiert die Beschleunigung des Entwicklungsprozesses. Diese Ansätze vernachlässigen jedoch meist Rationalisierungspotenziale einer Wiederverwendung von bereits entwickelten Maschinenbestandteilen zur schnelleren Maschinenbereitstellung.

Ein großes Einsparpotenzial im Bereich der Maschinenentwicklung liegt somit darin, Maschinenteile mehrfach in eine Maschine oder in mehrere Maschinen einzubauen. Leider ist es häufig so, dass solche möglichen Wiederverwendungen nicht realisiert werden, da in Frage kommende Teile schlicht und ergreifend nicht bekannt sind oder nicht gefunden werden.

Ein mögliches Mittel zum Auffinden von Teilen sind Klassifizierungen. Die Herangehensweise, Teile oder Objekte bezogen auf den Entwicklungsprozess von Maschinen zu klassifizieren, erfolgt grob in folgenden Kategorien:
- Zunächst erfolgt ein Aufbau expliziter Stammdaten. Hierbei ist eine Erstellung von Maschinenteilen nur zulässig, wenn diese von einer bestimmten Klasse abgeleitet werden. Diese Teile können dann wiederverwendet werden. Nur äußerst standardisierte Systeme erlauben eine solche Vorgehensweise.
- Bei der Neuanlage eines Bauteils wird die Zuweisung einer Klasse vom System gefordert. Dies bedeutet einen zusätzlichen Arbeitsaufwand.

Die Aufgabe der vorliegenden Erfindung besteht darin, ein Verfahren bereitzustellen, mit dem das Herstellen einer Maschine vereinfacht wird. Darüber hinaus soll eine entsprechende Vorrichtung zum vereinfachten Herstellen von Maschinen bereitgestellt werden.

Erfindungsgemäß wird diese Aufgabe gelöst durch ein Verfahren zum Herstellen einer zweiten Maschine durch
- Vorgeben einer Funktion einer ersten Maschine in einem ersten Entwicklungsprojekt,
- Ermitteln eines Lösungsprinzips für die Funktion im Rahmen des ersten Entwicklungsprojekts,
- Implementieren einer ersten Komponente der ersten Maschine auf der Basis des Lösungsprinzips,
- ausgelöst durch das Implementieren der ersten Komponente automatisches Generieren oder Aufsuchen einer dem Lösungsprinzip entsprechenden Klasse in einer Teilebibliothek sowie Kopieren der implementierten ersten Komponente in diese Klasse der Teilebibliothek,
- Auswählen der automatisch generierten oder aufgesuchten Klasse in der Teilebibliothek in einem zweiten Entwicklungsprojekt für die zweite Maschine,
- ausgelöst durch das Auswählen automatisches Anbieten der kopierten implementierten ersten Komponente aus der Klasse der Teilebibliothek und
- Implementieren einer zweiten Komponente der zweiten Maschine in dem zweiten Entwicklungsprojekt anhand der kopierten implementierten ersten Komponente der Teilebibliothek und
- Fertigen der zweiten Maschine anhand der implementierten zweiten Komponente.

Darüber hinaus wird erfindungsgemäß bereitgestellt eine Vorrichtung zum Herstellen einer zweiten Maschine umfassend
- eine Erfassungseinrichtung zum Erfassen einer vorgegebenen Funktion einer ersten Maschine in einem ersten Entwicklungsprojekt und eines Lösungsprinzips für die Funktion im Rahmen des ersten Entwicklungsprojekts und zum Implementieren einer ersten Komponente der ersten Maschine auf der Basis des Lösungsprinzips,
- eine Datenverarbeitungseinrichtung, die dazu ausgelegt ist, ausgelöst durch das Implementieren der ersten Komponente eine dem Lösungsprinzip entsprechenden Klasse in einer Teilebibliothek automatisch zu generieren oder aufzusuchen sowie die implementierte erste Komponente in die generierte Klasse der Teilebibliothek zu kopieren, wobei
- die Erfassungseinrichtung ausgelegt ist zum Auswählen der automatisch generierten oder aufgesuchten Klasse in der Teilebibliothek in einem zweiten Entwicklungsprojekt für die zweite Maschine, ausgelöst durch das Auswählen zum automatischen Anbieten der kopierten implementierten ersten Komponente aus der Klasse der Teilebibliothek und zum Implementieren einer zweiten Komponente der zweiten Maschine in dem zweiten Entwicklungsprojekt anhand der kopierten implementierten ersten Komponente der Teilebibliothek und wobei
- die Vorrichtung eine Fertigungseinrichtung zum Fertigen der zweiten Maschine anhand der implementierten zweiten Komponente aufweist.

In vorteilhafter Weise erfolgt also das Herstellen einer Maschine aufgrund eines verbesserten Entwurfverfahrens. Die Verbesserung beruht darauf, dass eine einmal implementierte Komponente zum Implementieren einer weiteren Komponente wiederverwendet wird. Dazu erfolgt systematisch eine Zuweisung einer implementierten ersten Komponente zu einem Lösungsprinzip, welches seinerseits in einem Entwicklungsprojekt einer Funktion zugeordnet ist. Damit ist diese erste Komponente dem Lösungsprinzip als abstraktes Wirkprinzip zugeordnet. Diese Zuordnung zu dem abstrakten Lösungsprinzip wird nun dazu genutzt, um dieses Lösungsprinzip in einer Teilebibliothek bzw. Datenbank als eigene Klasse zu erkennen bzw. zu definieren. Da nun für diese Klasse in dem Entwicklungsprojekt bereits eine Komponente real implementiert wurde, kann diese Implementierung in die Teilebibliothek für die Wiederverwendung übernommen werden. Dazu wird die implementierte erste Komponente in die Teilebibliothek übernommen bzw. kopiert.

Beim Durchführen eines weiteren Entwicklungsprojekts oder beim Fortsetzen des ersten Entwicklungsprojekts kann eine weitere Implementierung des Lösungsprinzips nun dadurch erreicht werden, dass in der Teilebibliothek die entsprechende Klasse gewählt wird, wodurch automatisch die zuvor für die Klasse abgespeicherte Implementierung angeboten wird. Die gespeicherte Implementierung kann nun für die zweite reale Implementierung in dem entsprechenden Entwicklungsprojekt übernommen bzw. genutzt werden. Gegebenenfalls wird die zweite Implementierung gegenüber der ersten Implementierung noch geringfügig abgewandelt. Schließlich kann die Maschine nun gemäß der vereinfacht erstellten Implementierung der zweiten Komponente gefertigt werden. Die Entwicklungsphase der zweiten Komponente ist damit deutlich vereinfacht.

Entsprechend einer Weiterentwicklung wird bei dem Implementieren eine Relation zwischen der implementierten ersten Komponente und dem Lösungsprinzip erstellt, und dieses Erstellen der Relation löst das automatische Generieren der Klasse aus. Bei dem Schaffen der Relation wird nämlich verdeutlicht, dass es sich bei dem Lösungsprinzip um eine Klasse handelt, für die bereits eine reale Implementierung vorliegt. Ein derartiges Gefüge von Klasse und Implementierung kann nun direkt in die Teilebibliothek bzw. in die Datenbank für erneute Verwendung hinterlegt werden.

Die Relation kann eine semantische Bedeutung wie "wird mechanisch implementiert durch", oder "wird elektrisch implementiert durch", oder "wird steuerungstechnisch implementiert durch" besitzen. Damit lässt sich in der Teilebibliothek eine weitere Information hinterlegen, welche in dem jeweiligen Entwicklungsprojekt weiter genutzt werden kann.

Die erste Maschine kann mit der zweiten Maschine und das erste Entwicklungsprojekt mit dem zweiten Entwicklungsprojekt identisch sein. Dies bedeutet, dass im Rahmen eines einzigen Entwicklungsprojekts eine einzige Maschine entwickelt wird und die Implementierung eines Lösungsprinzips für die Maschine mehrfach genutzt wird. Beispielsweise besitzt die Maschine mehrere Drehtische oder andere reale Komponenten. Bei der Implementierung des ersten Drehtisches wird die Datenbank mit dieser Implementierung und der dazugehörigen Klasse gefüttert. Bei der Implementierung des zweiten Drehtisches kann in dem Entwicklungsprojekt nun die Implementierung des ersten Drehtisches aus der Datenbank genutzt werden. Dadurch verkürzt sich das Entwurfsverfahren. Die Maschine kann entsprechend kostengünstiger hergestellt werden.

Die Funktion, für die im Rahmen des Entwicklungsprojekts ein Lösungsprinzip ermittelt wird, kann sich beispielsweise darauf beziehen, mit einem Produkt zu interagieren. Die Funktion der herzustellenden Maschine bezieht sich also darauf, dass eine Interaktion der später vollendeten Maschine mit einem Produkt, das beispielsweise durch sie hergestellt oder verarbeitet wird, erfolgt.

Bei dem Interagieren mit dem Produkt kann es sich beispielsweise um ein Drehen, ein Verschieben oder ein Greifen handeln. Die herzustellende Maschine dreht, verschiebt oder greift im späteren Einsatzfall also ein jeweiliges Produkt. Das Interagieren ist natürlich nicht auf die beschriebenen Varianten beschränkt. Vielmehr kann es sich bei dem Interagieren beispielsweise auch um ein Erwärmen, Lackieren, Bohren, Fräsen usw. handeln.

Das Lösungsprinzip, mit dem obige Funktion erzielt wird, kann beispielsweise ein Drehtisch, ein Förderband oder ein Greifer sein. Entsprechend den anderen Interaktionen kann es sich auch um eine Heizplatte, einen Sprühkopf, eine Bohrspindel, eine Frässpindel usw. handeln. Für jedes dieser Lösungsprinzipien kennt der Bediener geeignete reale Implementierungen oder sie werden ihm beispielsweise aus der Teilebibliothek vorgeschlagen.

Die implementierte erste und/oder zweite Komponente kann eine Parametrierung einer real existierenden Komponente beinhalten. Der Begriff Parametrierung ist hier sehr weit zu verstehen und beinhaltet beispielsweise elektrische und/oder mechanische Parameter. Darüber hinaus kann eine Parametrierung auch beispielsweise eine Bestellnummer oder eine Typenbezeichnung beinhalten. In jedem Fall wird durch die Parametrierung der implementierten Komponente ein realer Bezug gegeben.

Die oben im Zusammenhang mit dem erfindungsgemäßen Verfahren geschilderten Merkmale können sinngemäß als funktionelle Merkmale auch für die erfindungsgemäße Vorrichtung verwendet werden.

Der Einsatzbereich der vorliegenden Erfindung ist sehr weitreichend. Grundsätzlich lässt sich damit beinahe jede Maschine herstellen. Besonders vorteilhaft ist natürlich die Herstellung von Sondermaschinen mit geringer Stückzahl. Bei diesen Maschinen ist der Entwicklungsaufwand gegenüber den übrigen Herstellungskosten verhältnismäßig hoch. Ein typisches Beispiel einer solchen Sondermaschine wäre eine Firmwarelademaschine, von denen weltweit nur sehr wenige hergestellt werden. Eine weitere Möglichkeit für den Einsatz der vorliegenden Erfindung wäre bei der Herstellung von Maschinen denkbar, die zur Schleifwalzenproduktion dienen. Es können aber auch Großmaschinen und Anlagen von der Erfindung profitieren, wie etwa Reifenproduktionsmaschinen, Gepäckförderanlagen und dergleichen. Darüber hinaus können auch beispielsweise spezielle Roboter oder Werkzeugmaschinen mit dem erfindungsgemäßen Verfahren hergestellt werden.

Die vorliegende Erfindung wird nun anhand der beigefügten Zeichnungen näher erläutert, in denen zeigen:
- FIG 1: ein Beispiel für die zu durchlaufenden Abstraktionsebenen während eines konstruktiven Prozesses; und
- FIG 2: einen Zusammenhang zwischen der Zuweisung einer realen Implementierung und der Klassifizierung in einer Datenbank.

Die nachfolgend näher geschilderten Ausführungsbeispiele stellen bevorzugte Ausführungsformen der vorliegenden Erfindung dar. Dabei ist zu beachten, dass die einzelnen Merkmale nicht nur in der jeweils geschilderten Kombination, sondern auch beispielsweise in Alleinstellung oder in anderen technisch sinnvollen Kombinationen realisiert werden können.

Es soll eine Maschine und insbesondere eine Sondermaschine, d. h. eine Maschine mit geringer Stückzahl bzw. Einzelmaschine, kostengünstig hergestellt werden. Bei der Maschine handelt es sich beispielsweise um eine der oben genannten Arten, z. B. eine Firmwarelademaschine.

Der größte Aufwand bei der Herstellung von Sondermaschinen besteht in deren Entwicklung. Gegebenenfalls kann zwar auf bekannte Module bzw. Teilkomponenten zurückgegriffen werden, aber deren elektrisches und mechanisches Zusammenwirken ist dann individuell zu konfigurieren.

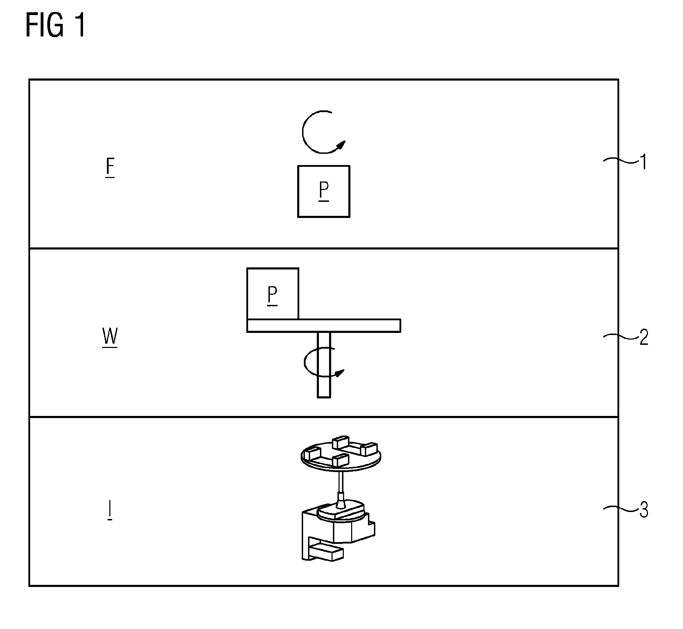

Entlang eines Entwicklungsprozesses durchläuft der Konstrukteur bzw. Entwickler verschiedene Abstraktionsebenen. Derartige Abstraktionsebenen sind in FIG 1 dargestellt. Dementsprechend bezieht sich eine hohe Abstraktionsebene 1 auf Funktionen F, die eine herzustellende Maschine erfüllen muss. Darunter ist die Abstraktionsebene 2 angesiedelt, die sich auf ein Wirk- oder Lösungsprinzip W bezieht. Die unterste Abstraktionsebene 3 bezieht sich auf eine reale Implementierung I.

In eingängigen Konstruktionsmethoden der Mechanik beispielsweise wird ausgehend von einer Anforderungsdefinition eine sogenannte funktionale Modellierung empfohlen. Diese soll auf abstrakte Weise beschreiben, was die Maschine bzw. die Komponente können muss, d. h. welche Funktion oder welche Funktionen sie erfüllen muss. In dem Beispiel von FIG 1 soll die Maschine die Funktion erfüllen, ein Produkt P zu drehen, also mit dem Produkt zu interagieren.

In einem weiteren Schritt des Entwicklungsprozesses auf der zweiten Abstraktionsebene 2 werden sogenannte Wirkprinzipien W (auch Lösungsprinzipien genannt) definiert, welche die geforderten Funktionen F aus der ersten Abstraktionsebene implementieren. Die Funktion F "Produkt drehen" wird beispielsweise durch das Lösungsprinzip "Drehtisch" implementiert, was symbolisch in der zweiten Abstraktionsebene von FIG 1 dargestellt ist.

Das konkrete Wirk- oder Lösungsprinzip "Drehtisch" ist nun Vorlage für die Entwicklung einer realen Implementierung in der dritten Abstraktionsebene 3. Als reale Implementierung I muss im vorliegenden Beispiel ein realer Drehtisch entwickelt bzw. konfiguriert werden. Dazu sind beispielsweise konkrete geometrische Parameter wie Scheibendurchmesser, Achshöhe, aber auch Befestigungselemente und Antrieb etc. festzulegen bzw. zu parametrieren. Gegebenenfalls kann einfach mit einer Bestellnummer eine Gesamtkonfiguration einer Komponente festgelegt werden, die als reale Implementierung I eingesetzt werden kann.

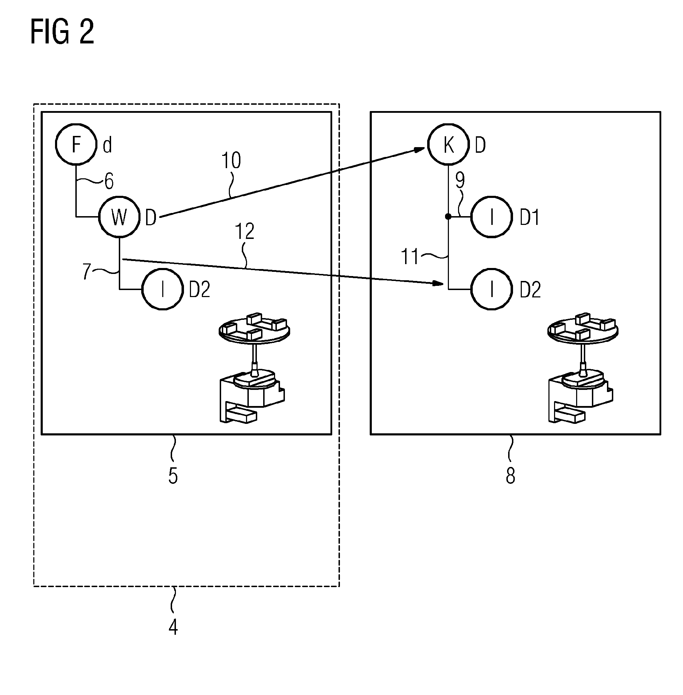

FIG 2 zeigt nun die Entwicklung einer neuen Maschine, die in einen Herstellungsprozess 4 integriert ist. Nach der Entwicklung erfolgt nämlich die Fertigung der entwickelten Maschine.

Die Entwicklung der Maschine wird in FIG 2 durch ein Entwicklungsprojekt 5 symbolisiert. Das Entwicklungsprojekt 5 kann in einem Userinterface intuitiv übersichtlich dargestellt werden. Die zu entwickelnde Maschine soll hier wie im Beispiel von FIG 1 eine Funktion F besitzen, die symbolisch als übergeordneter Kreis dargestellt ist. Diese Funktion soll hier konkret die Funktion d sein, die für "Produkt drehen" steht. Damit ist der Entwicklungsprozess in der ersten Abstraktionsebene 1 durchlaufen.

Es müssen nun die weiteren Abstraktionsebenen 2 und 3 durchlaufen werden, um eine konkrete Implementierung zu finden. Dazu wird in der zweiten Abstraktionsebene 2 das Lösungsprinzip W festgelegt. In der Darstellung von FIG 2 wird dazu ein mit "W" beschrifteter Kreis unterhalb und etwas eingerückt unter dem Funktionskreis als dessen Implementierung abgebildet. Eine abknickende Linie 6 verbindet die beiden Kreise von Funktion und Lösungsprinzip und stellt deren Relation dar. Im konkreten Beispiel dient als Lösungsprinzip W ein Drehtisch D.

In einem weiteren Konkretisierungsschritt muss der Drehtisch D real implementiert werden. Eine solche Implementierung wird in dem Userinterface von FIG 2 als Kreis mit einem "I" dargestellt. Es ergibt sich eine Relation 7 zwischen der realen Implementierung I und dem Lösungsprinzip W. Als reale Implementierung I wird hier von dem Nutzer beispielsweise ein Drehtisch D2 konfiguriert. Dazu gibt der Nutzer die entsprechenden Daten bzw. Parameter in das Userinterface ein.

Zur Beschleunigung des Entwicklungsprozesses wird nun vorgesehen, dass die konkrete Implementierung I des Drehtisches D2 für weitere Implementierungen oder weitere Entwicklungsprojekte gegebenenfalls auch anderer Nutzer zur Verfügung steht. Somit kann im Zuge einer Wiederverwendung dann einfach auf eine solche konkrete Implementierung zurückgegriffen werden.

Wird beispielsweise im Rahmen der Entwicklung einer Maschine eine Datenbank bzw. Teilebibliothek 8 verwendet, so kann auf die dort gespeicherten Implementierungen mit wenig Aufwand zurückgegriffen werden. Die Teilebibliothek 8 kann verschiedene Klassen K von Implementierungen aufweisen. Beispielsweise wird eine solche Klasse in dem Userinterface durch ein "K" in einem Kreis dargestellt. Eine konkrete Klasse K, die sich auf einen Drehtisch D bezieht, kann in der Teilebibliothek 8 bereits gespeichert sein. Diese Klasse von Drehtischen kann auch bereits mit einer Implementierung eines Drehtisches D1 gefüllt sein. Dazu wird wie in dem Entwicklungsprojekt 5 für den Drehtisch D1 beispielsweise ein Kreis mit einem "I" dargestellt. Die Zuweisung der konkreten Implementierung kann graphisch durch eine Relation 9 dargestellt werden, die die Kreise von Klasse K und Implementierung I verbindet.

Wird nun im Rahmen des Entwicklungsprojekts 5 das Lösungsprinzip Drehtisch D der Klasse Drehtisch D gemäß Pfeil 10 äquivalent zugeordnet, so wird auch die reale Implementierung Drehtisch D2 einschließlich der Relation 7 in die Teilebibliothek 8 übertragen bzw. kopiert. Es entsteht dabei entsprechend eine Relation 11 zwischen dem kreisförmigen Implementierungssymbol I und dem kreisförmigen Klassensymbol K. Der Pfeil 12 deutet dementsprechend an, dass die Relation 7 des Entwicklungsprojekts 5 auf die Relation 11 der Teilebibliothek 8 führt.

Dies bedeutet, dass bei expliziter Nennung des Wirkprinzips (z. B. Drehtisch D) und der Zuweisung 7 der realen Bauteile (Drehtisch D2) das Wirkprinzip als Abstraktion des realen Drehtischs verstanden werden kann. Somit ist dies gleichzeitig die Klassifikation in der Teilebibliothek 8. Folglich kann bei jedem Entwicklungsprojekt alleine durch die Zuweisung 7 des jeweils neu konstruierten Bauteils (Drehtisch D2) zum jeweiligen Wirkprinzip (Drehtisch D) eine Klassifizierung stattfinden, die sich in einer Datenbank bzw. Teilebibliothek nutzen lässt.

Wird nun im weiteren Verlauf des Entwicklungsprojekts 5 das Lösungsprinzip Drehtisch D erneut implementiert, so kann dies beispielsweise dadurch erfolgen, dass in der Teilebibliothek 8 die Klasse Drehtisch D aufgerufen wird. Daraufhin werden in dem Userinterface automatisch die bereits implementierten Drehtische D1 und D2 als mögliche Implementationen angezeigt. Generell werden alle Implementationen einer Klasse angezeigt, wenn diese aufgerufen wird. Beispielsweise durch Drag-and-Drop kann der Nutzer nun eine reale Implementierung (z. B. Drehtisch D1) von der Teilebibliothek 8 in das Entwicklungsprojekt 5 übernehmen. Dabei wird auch die Relation 9 zur Klasse bzw. zum Wirkprinzip W übernommen.

Eine weitere Variante des erfindungsgemäßen Prinzips besteht darin, dass bei Implementierung eines Wirk- bzw. Lösungsprinzips in dem Entwicklungsprojekt 5 eine entsprechende Klasse in der Datenbank bzw. Teilebibliothek 8 noch nicht vorhanden ist. In diesem Fall kann beispielsweise durch Schaffen des Lösungsprinzips "Drehtisch" D im Entwicklungsprojekt 5 automatisch die entsprechende Klasse "Drehtisch" D in der Teilebibliothek 8 generiert werden. Alternativ kann auch erst mit Implementierung des Drehtischs D2 die Klasse "Drehtisch" D einschließlich der Implementierung Drehtisch D1 oder D2 generiert werden. Eine weitere Alternative besteht darin, dass erst mit der Zuweisung 7 einer Implementierung zu einem Lösungsprinzip das entsprechende Paar von Klasse und Implementierung in der Teilebibliothek 8 gegebenenfalls einschließlich der Relation 9 bzw. 11 erzeugt wird.

Ein besonderer Vorteil der vorliegenden Erfindung besteht also darin, dass eine Klassifizierung von Bauteilen automatisch bei jedem Projektdurchlauf erfolgt, indem die vorhandenen Beschreibungen genutzt werden. Dadurch ist eine erhebliche Reduktion von Entwicklungsaufwänden erreichbar hinsichtlich:
- weniger Neukonstruktionen, da alle Bauteile klassifiziert sind;
- weniger Aufwand zur Klassifikation von Bauteilen; und
- weniger Aufwand zur Einarbeitung von neuen Mitarbeitern in Entwicklungsprojekte, da durch die logischen Abstrahierungen das Maschinenverständnis gefördert wird.

## Patentansprüche

1. Verfahren zum Herstellen einer zweiten Maschine **gekennzeichnet durch**
- Vorgeben einer Funktion (F) einer ersten Maschine in einem ersten Entwicklungsprojekt (5),
- Ermitteln eines Lösungsprinzips (W) für die Funktion (F) im Rahmen des ersten Entwicklungsprojekts (5),
- Implementieren einer ersten Komponente (D2) der ersten Maschine auf der Basis des Lösungsprinzips (W),
- ausgelöst **durch** das Implementieren der ersten Komponente (D2) automatisches Generieren oder Aufsuchen einer dem Lösungsprinzip (W) entsprechenden Klasse (K) in einer Teilebibliothek (8) sowie Kopieren der implementierten ersten Komponente (D2) in diese Klasse (K) der Teilebibliothek (8),
- Auswählen der automatisch generierten oder aufgesuchten Klasse (K) in der Teilebibliothek (8) in einem zweiten Entwicklungsprojekt für die zweite Maschine,
- ausgelöst **durch** das Auswählen automatisches Anbieten der kopierten implementierten ersten Komponente (D2) aus der Klasse (K) der Teilebibliothek (8) und
- Implementieren einer zweiten Komponente der zweiten Maschine in dem zweiten Entwicklungsprojekt anhand der kopierten implementierten ersten Komponente (D2) der Teilebibliothek (8) und
- Fertigen der zweiten Maschine anhand der implementierten zweiten Komponente.

2. Verfahren nach Anspruch 1, wobei bei dem Implementieren eine Relation (6, 7, 9, 11) zwischen der implementierten ersten Komponente (D2) und dem Lösungsprinzip (W) erstellt wird, und dieses Erstellen der Relation (6, 7, 9, 11) das automatische Generieren der Klasse (K) auslöst.

3. Verfahren nach Anspruch 1 oder 2, wobei die erste Maschine mit der zweiten Maschine und das erste Entwicklungsprojekt (5) mit dem zweiten Entwicklungsprojekt identisch sind.

4. Verfahren nach einem der vorhergehenden Ansprüche, wobei die Funktion (F) sich darauf bezieht, mit einem Produkt zu interagieren.

5. Verfahren nach Anspruch 4, wobei das Interagieren ein Drehen, Verschieben oder Greifen umfasst.

6. Verfahren nach Anspruch 4, wobei das Lösungsprinzip (W) ein Drehtisch, ein Förderband oder ein Greifer ist.

7. Verfahren nach einem der vorhergehenden Ansprüche, wobei die implementiere erste und/oder zweite Komponente eine Parametrierung einer real existierenden Komponente beinhaltet.

8. Verfahren nach einem der Ansprüche 2 bis 7, wobei die Relation (6, 7, 9, 11) eine semantische Bedeutung wie "wird mechanisch implementiert durch", oder "wird elektrisch implementiert durch", oder "wird steuerungstechnisch implementiert durch" besitzt.

9. Vorrichtung zum Herstellen einer zweiten Maschine **gekennzeichnet durch**
- eine Erfassungseinrichtung zum Erfassen einer vorgegebenen Funktion (F) einer ersten Maschine in einem ersten Entwicklungsprojekt (5) und eines ermittelten Lösungsprinzips (W) für die Funktion (F) im Rahmen des ersten Entwicklungsprojekts und zum Implementieren einer ersten Komponente (D2) der ersten Maschine auf der Basis des Lösungsprinzips (W),
- eine Datenverarbeitungseinrichtung, die dazu ausgelegt ist, ausgelöst **durch** das Implementieren der ersten Komponente (D2) eine dem Lösungsprinzip (W) entsprechenden Klasse (K) in einer Teilebibliothek (8) automatisch zu generieren oder aufzusuchen sowie die implementierte erste Komponente in die generierte Klasse (K) der Teilebibliothek (8) zu kopieren, wobei
- die Erfassungseinrichtung ausgelegt ist zum Auswählen der automatisch generierten oder aufgesuchten Klasse (K) in der Teilebibliothek (8) in einem zweiten Entwicklungsprojekt für die zweite Maschine, ausgelöst **durch** das Auswählen zum automatischen Anbieten der kopierten implementierten ersten Komponente (D2) aus der Klasse (K) der Teilebibliothek (8) und zum Implementieren einer zweiten Komponente der zweiten Maschine in dem zweiten Entwicklungsprojekt anhand der kopierten implementierten ersten Komponente (D2) der Teilebibliothek (8) und wobei
- die Vorrichtung eine Fertigungseinrichtung zum Fertigen der zweiten Maschine anhand der implementierten zweiten Komponente aufweist.
